# EUROPEAN PATENT SPECIFICATION

(11) **EP 4 376 074 B1**
(45) Date of publication and mention of the grant of the patent: **08.07.2026**
(21) Application number: 22209634.9
(22) Date of filing: 25.11.2022
(51) Int. Cl.: H10W 70/65, H10W 40/25, H10W 72/00, H10W 90/00, H10W 72/50

(54) **CONDUCTOR RAIL, AND POWER SEMICONDUCTOR MODULE ARRANGEMENT COMPRISING A CONDUCTOR RAIL**
STROMSCHIENE UND LEISTUNGSHALBLEITERMODULANORDNUNG MIT EINER STROMSCHIENE
RAIL CONDUCTEUR ET ENSEMBLE MODULE SEMI-CONDUCTEUR DE PUISSANCE COMPRENANT UN RAIL CONDUCTEUR

(43) Date of publication of application: 29.05.2024
(73) Proprietor: Infineon Technologies AG, 85579 Neubiberg (DE)
(72) Inventor: TSCHIRBS, Roman Lennart, 59494 Soest (DE); NOTTELMANN, Regina, 59505 Bad Sassendorf (DE)
(74) Representative: Westphal, Mussgnug & Partner, Patentanwälte mbB

(56) References cited:
- EP-A1- 2 071 626
- EP-A1- 3 748 835
- EP-A1- 4 086 954
- WO-A1-2014/181638
- DE-A1- 3 440 925
- GB-A- 914 034
- JP-A- 2001 036 001
- JP-A- 2004 319 740
- JP-A- 2016 063 179
- JP-A- H02 178 954
- US-A1- 2009 039 498
- US-A1- 2018 166 410
- US-A1- 2022 301 955

## Description

### TECHNICAL FIELD

The instant disclosure relates to a conductor rail for a power semiconductor module arrangement, and to a semiconductor module arrangement comprising a conductor rail.

### BACKGROUND

Document JP H02 178954 A discloses a semiconductor device, wherein a top face of a MOS type bipolar transistor chip is fixed onto a metallic bottom plate of a vessel and has a source pad and a gate pad. A source electrode body and a gate electrode body are fastened onto the bottom plate through an insulating plate respectively, and the source pad and the source electrode body and the gate pad and the gate electrode body are connected by conductors respectively. The end sections of a spiral reciprocating wiring are fixed at the end sections of the source electrode body and the gate electrode body, and another end of the spiral reciprocating wiring is projected to the upper section of the vessel and a source gate terminal is shaped. The spiral reciprocating wiring is formed to a spiral shape by holding an insulating layer between copper strips and twisting the copper strips.

Power semiconductor modules having a ceramic substrate may be damaged by mechanical stresses transmitted to the substrate by external connections for example. To improve the mechanical decoupling, Document DE 34 40 925 A1 proposes making connection elements between the metallisation on a substrate and external connections of highly flexible conductors, preferably feathered metal-sheet strips. Feathered metal-sheet strips are very flexible but nevertheless sufficiently dimensionally stable for simple assembly of the module housing.

Document JP 2001 036001 A discloses a power semiconductor module, wherein a net-like metallic fine wire is used for connecting the line between an emitter electrode and an electrode terminal for an emitter.

Document WO 2014/181638 A1 discloses a method for manufacturing a semiconductor device comprising: a connecting step for connecting a first adherend and a second adherend to each other by means of wiring; a movement step, subsequent to the connecting step, for moving at least one of the first adherend and the second adherend, thereby moving the first adherend relative to the second adherend; and a fixing step for fixing the relative position of the first adherend in relation to the second adherend.

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and an optional second metallization layer deposited on a second side of the substrate layer. The controllable semiconductor elements are mounted, for example, on the first metallization layer. The second metallization layer may optionally be attached to a base plate.

Electrically conducting elements are usually provided that allow to electrically contact the semiconductor elements from outside of the housing. Such electrically conducting elements may include simple terminal elements as well as conductor rails or bus bars, for example. Terminal elements are generally configured to provide control signals to the substrate and the components mounted thereon, and conductor rails are configured to provide a supply voltage to the power semiconductor module arrangement. That is, the terminal elements are only used to conduct low currents, while the conductor rails need to be able to conduct comparably high load currents. The conductor rails, therefore, are usually implemented as large metal sheets that, due to their large cross-sectional area, have a low ohmic resistance. To form a stable mechanical and electrical connection between the substrate and the conductor rails, the conductor rails are generally soldered, sintered or welded to the substrate. The large metal sheets forming the conductor rails and the connections that are formed between the conductor rails and the substrate, however, are exposed to high thermo-mechanical stress during the operation of the power semiconductor module arrangement. There is a risk that, due to the thermo-mechanical stress, the connections between the conductor rails and the substrate are damaged or even destroyed before the end of the intended lifetime of the power semiconductor module arrangement such that the electrical connection between the conductor rail and the substrate can be diminished or interrupted entirely. The lifetime of the power semiconductor module arrangement, therefore, may be significantly reduced.

There is a need for a conductor rail that has a low ohmic resistance and which is less likely to come off the substrate during the intended lifetime of the power semiconductor module arrangement.

### SUMMARY

A conductor rail for a power semiconductor module arrangement includes a first end configured to be arranged inside a housing of the power semiconductor module arrangement, a second end configured to be arranged outside of the housing of the power semiconductor module arrangement, and at least a first section and a second section arranged successively between the first end and the second end along a length of the conductor rail, wherein the second section includes at least one flexible section, and the first section has a larger stiffness than each of the at least one flexible section. At least one of the at least one flexible section includes one or more braided wires, wherein each of the one or more braided wires includes a plurality of separate wires that are braided to form the braided wire, and wherein each of the one or more braided wires includes a first plurality of separate wires of a first kind, the wires of the first kind each having a first cross-sectional area, and one or more wires of a second kind each having a second cross-sectional area that is larger than the first cross-sectional area.

A power semiconductor module arrangement includes a housing, a substrate arranged inside the housing, and at least one conductor rail, wherein the first end of each of the at least one conductor rail is arranged inside the housing and electrically and mechanically coupled to the substrate, and the second end of each of the at least one conductor rail extends to the outside of the housing.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a three-dimensional view of another power semiconductor module arrangement.
Figure 3 is a three-dimensional view of a conventional conductor rail.
Figure 4 is a cross-sectional view of a conductor rail according to one example.
Figure 5 schematically illustrates different kinds of wires.
Figure 6 schematically illustrates a three-dimensional view of a conductor rail according to one embodiment of the disclosure.
Figure 7 schematically illustrates a three-dimensional view of a conductor rail according to another embodiment of the disclosure.
Figure 8, including Figures 8A and 8B, schematically illustrates the general principles of braided wires according to the invention.
Figure 9 schematically illustrates a three-dimensional view of a flat woven rope according to an embodiment of the disclosure.
Figure 10, including Figures 10A, 10B and 10C, schematically illustrates different three-dimensional views of a flexible section of a conductor rail according to an embodiment of the disclosure.
Figure 11 schematically illustrates a three-dimensional view of a flexible section of a conductor rail according to another embodiment of the disclosure.
Figure 12 schematically illustrates a three-dimensional view of a flexible section of a conductor rail according to an even further embodiment of the disclosure
Figure 13 schematically illustrates three dimensional view of second sections of a conductor rail according to embodiments of the disclosure.
Figure 14 schematically illustrates three-dimensional views of conductor rails according to embodiments of the disclosure.
Figure 15 schematically illustrates three-dimensional views of a conductor rail according to another embodiment of the disclosure.
Figure 16, including Figures 16A and 16B, schematically illustrates three-dimensional views of a conductor rail according to an even further embodiment of the disclosure.
Figure 17, including Figures 17A and 17B, schematically illustrates cross-sectional views of flexible sections of conductor rails according to embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

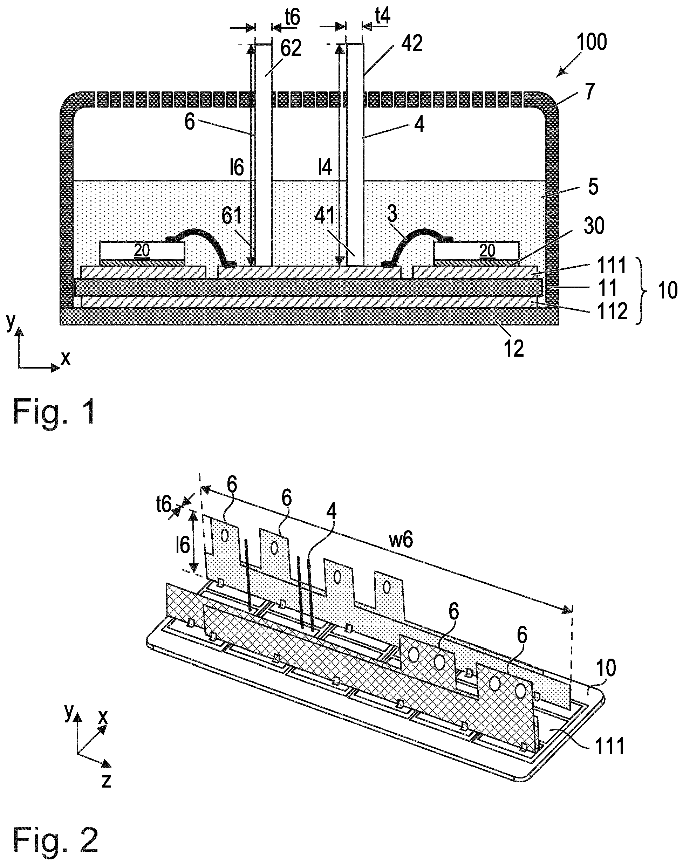

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AIN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AIN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 12 which forms a ground surface of the housing 7, while the housing 7 itself solely comprises sidewalls and a cover. This, however, is only an example. It is also possible that the housing 7 further comprises a ground surface and the substrate 10 and the base plate 12 be arranged inside the housing 7. In some power semiconductor module arrangements 100, more than one substrate 10 is arranged on a single base plate 12 or on the ground surface of a housing 7. According to another example, the base plate 12 is omitted and the substrate 10 itself forms a ground surface of the housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Electrical connections 3 may also include connection plates or conductor rails, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver powder, for example.

According to other examples, it is also possible that the second metallization layer 112 is a structured layer. It is further possible to omit the second metallization layer 112 altogether. It is generally also possible that the first metallization layer 111 is a continuous layer, for example.

The power semiconductor module arrangement 100 further includes terminal elements 4. Only one terminal element 4 is schematically illustrated in Figure 1. A power semiconductor module arrangement 100, however, generally may include a plurality of terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of each of the terminal elements 4 protrudes out of the housing 7. The terminal elements 4 may be electrically contacted from the outside at their respective second ends 42. A first part of the terminal elements 4 may extend through the inside of the housing 7 in a vertical direction y. The vertical direction y is a direction perpendicular to a top surface of the substrate 10, wherein the top surface of the substrate 10 is a surface on which the at least one semiconductor body 20 is mounted. The terminal element 4 illustrated in Figure 1, however, is only an example. Terminal elements 4 may be implemented in any other way and may be arranged anywhere within the housing 7. For example, one or more terminal elements 4 may be arranged close to or adjacent to the sidewalls of the housing 7. Terminal elements 4 could also protrude through the sidewalls of the housing 7 instead of through the cover. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example. The second ends 42 of the terminal elements 4 may be connected to a printed circuit board, for example (not illustrated in Figure 1).

The power semiconductor module arrangement 100 further comprises one or more conductor rails 6 (often also referred to as bus bars). Only one conductor rail 6 is exemplarily illustrated in Figure 1. A power semiconductor module arrangement 100, however, often comprises two or even more conductor rails 6. The terminal elements 4 are generally configured to conduct control signals to and from the substrate 10. Control signals usually comprise electrical signals of 15V or less and are configured to control the function of the different semiconductor bodies 20. It is, however, also necessary to provide supply voltages to the power semiconductor module arrangement 100. The power semiconductor module arrangement 100 switches from an off state (non-working state) to an on state (working state), for example, when a supply voltage is provided. Supply voltages are generally significantly higher with more than 100V, more than 300V, more than 600V and even up to several thousands of volts. A supply voltage can be between 500V and 10kV, or between 600V and 6.5kV, for example. The at least one conductor rail 6 is configured to provide such a supply voltage. During operation of the power semiconductor module arrangement 100, the conductor rails 6 may have to conduct load currents of more than 100A, more than 300A, or more than 600A, for example. It is even possible that load currents of up to several hundreds or even thousands of Amperes arise.

The terminal elements 4 generally comprise simple pins, as is exemplarily illustrated in Figure 2. The conductor rails 6, on the other hand, in order to be able to provide the significantly higher supply voltages as well as to be able to conduct the significantly higher currents, have a larger cross-sectional area as compared to the terminal elements 4. According to one example, therefore, each of the at least one conductor rail 6 comprises a metal sheet. This will be described in further detail below.

The terminal elements 4 that have to provide comparably small voltages (and currents) generally have a comparably small cross-sectional area. That is, a length 14 of a terminal element 4 between its first end 41 and its second end 42 is generally significantly larger than its greatest thickness (or width) t4. The terminal elements 4 may have a round, oval, square, or rectangular cross-sectional area, for example. That is, the terminal elements 4 may be simple pins. The greatest thickness t4 of a terminal element 4 may be defined by its diameter, its width or a greatest extension in a direction that is perpendicular to the length 14 (e.g., perpendicular to the vertical direction y). In a round terminal element 4, for example, the greatest thickness t4 is defined by the diameter of the terminal element 4, while in a terminal element 4 having a rectangular cross-section, the greatest thickness t4 is defined by the length of the longitudinal sides which are generally longer than the narrow sides. According to one example, each of the at least one terminal element 4 has a length 14 between its first and second end 41, 42 that is at least ten times, at least twenty times, or at least thirty times its greatest thickness t4.

Due to their comparably small cross sectional area, however, the terminal elements 4 may not be able to withstand the much higher load currents. A load current, therefore, may be provided by means of conductor rails 6. The power semiconductor module arrangement 100 may comprise at least two conductor rails 6, for example. One conductor rail 6 may be configured to be coupled to a positive potential (e.g., DC+), and another conductor rail 6 may be configured to be coupled to a negative potential (e.g., DC-). In order to be able to withstand the comparably large load currents, each conductor rail 6 has a length 16 and a width w6 that are larger (e.g., at least 10 times larger, at least 30 times larger, or even at least 50 times larger) than a thickness t6 of the conductor rail 6 (see, e.g., Figures 1 and 2). A length 16 of a conductor rail 6 may be larger or may essentially equal the width w6 of the conductor rail 6, for example. It is, however, also possible that the width w6 is larger than the length 16 of the conductor rail 6, as is schematically illustrated in Figure 2. A length 16 of a conductor rail 6 may be less than ten times, or less than five times the width w6 of the conductor rail 6, for example. The width w6 represents the greatest extension of the conductor rail 6 in a direction perpendicular to its length 16, similar to what has been described with respect to the terminal elements 4 above. By significantly increasing the width w6, the cross-sectional area of the conductor rails 6 is large (e.g., at least five times, at least ten times, or at least thirty times) as compared to the cross-sectional area of the terminal elements 4.

Each of the at least two conductor rails 6 comprises a first end 61 that is electrically and mechanically coupled to the substrate 10, and a second end 62 extending to the outside of the housing 7. The first end 61 of a conductor rail 6 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. According to one example, a connection between the first end 61 of a conductor rail 6 and the substrate 10 may be formed by means of ultrasonic welding. According to one example, a thickness t6 of the conductor rails 6 is between 0.5 and 1.5mm (millimeters), e.g., 1mm. The conductor rails 6 illustrated is Figures 1 and 2 are straight between their first and second end 61, 62. It is, however, also possible that a conductor rail 6 is bent at least once along its length 16.

The conductor rails 6 are generally required to fulfill a plurality of different requirements. For example, the conductor rails 6 are generally required to conduct comparably high currents. As has been described above, the cross-sectional area of a conductor rail 6 may be large (ohmic losses are low) in order to be able to conduct higher currents. The large metal sheets as schematically illustrated, for example, in Figure 2, however, are rather stiff. That is, the metal sheets may not be bent easily. When exposed to typical thermo-mechanical stress during the operation of the power semiconductor module arrangement 100, there is a risk that the connections formed between the large conductor rails 6 and the substrate 10 are damaged or even destroyed during the intended lifetime of the power semiconductor module arrangement such that the electrical connections between the conductor rails 6 and the substrate 10 can be diminished or interrupted entirely. That is, the lifetime of the power semiconductor module arrangement 100 may be significantly decreased.

With further reference to Figure 1, the power semiconductor module arrangement 100 may further include an encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 and the at least one conductor rail 6 may be partly embedded in the encapsulant 5. At least their second ends 42, 62, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged on the substrate 10 inside the housing 7, from certain environmental conditions and mechanical damage.

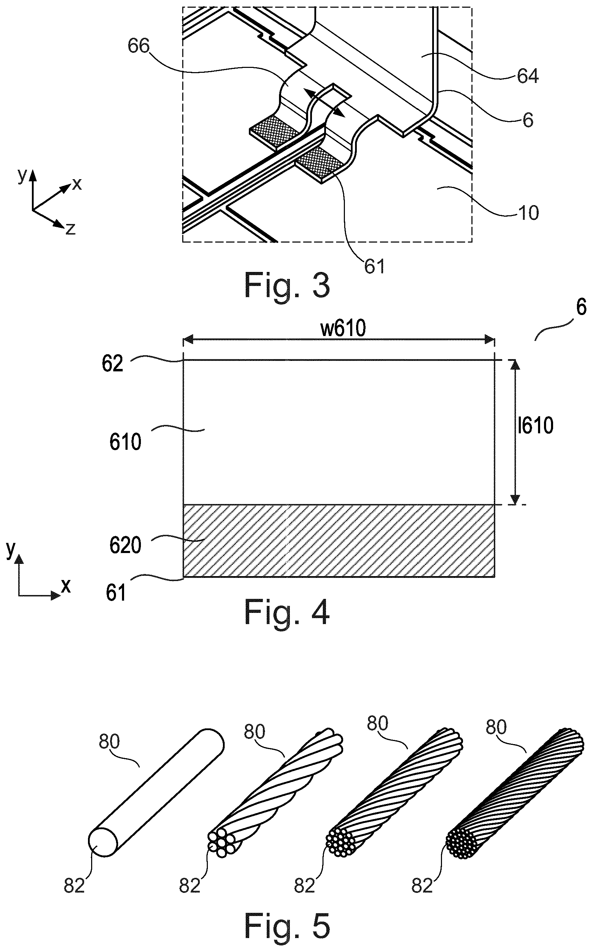

As is schematically illustrated in Figure 3, a conductor rail 6 often comprises a large metal sheet 64 having one or more legs 66. The legs 66 are arranged at the first end 61 of the conductor rail 6 and are electrically and mechanically connected to the substrate (e.g., by means of an (ultrasonic) welding joint, a solder joint, or a sinter connection). The large metal sheet 64 and the legs 66 are often monolithically formed. For example, the conductor rail 6 comprising the large metal sheet 64 and one or more legs-66 may be stamped out of an even larger metal sheet. The legs 66 have a width that is less than the width of the large metal sheet 64. The legs 66, however, are still comparably stiff. Further, any thermo-mechanical stress exerted on the legs 66 (indicated by means of an arrow in Figure 3) is directly transferred to the large metal sheet 64, and vice versa. The connections formed between the legs 66 and the substrate 10, therefore, may degrade over time, as has been described above.

According to one example, therefore, a conductor rail 6 comprises a first section 610 and a second section 620 arranged successively between the first end 61 and the second end 62 along a length 16 of the conductor rail 6. This is schematically illustrated in Figure 4. The first section 610 may comprise a metal sheet having a comparably large cross-section, similar to what has been described with respect to the large metal sheet 64 above. That is, a length 1610 and a width w610 may be significantly larger than a thickness of the first section 610. The first section 610, therefore, is able to conduct the comparably large currents provided via the conductor rail 6. The first section 610 is comparably stiff, similar to what has been described with respect to conventional conductor rails above. The second section 620, on the other hand, comprises at least one flexible section (as will be described in more detail below). That is, at least parts of the second section 620 may be more easily bent in at least one direction in space, as compared to the first section 610. Only little force is required in order to bend or fold the flexible section of the second section 620 in at least one direction in space. For example, a stiffness of the first section 610 may be at least five times, at least ten times, or at least fifty times the stiffness of the flexible section of the second section 620. At the same time, the second section 620 is configured to conduct the same currents as the first section 610. When the conductor rail 6 is arranged in its final mounting position, the entire second section 620 may be arranged inside the housing 7, while the first section 610 protrudes through the housing 7 to the outside of the housing 7.

According to one example, the second section 620 (i.e., the flexible section of the second section 620), instead of a single, large metal sheet, comprises a plurality of separate conducting elements. Each of the plurality of separate conducting elements has a cross-sectional area that is small as compared to the cross-sectional area of the first section 610. For example, a cross-sectional area of the first section 610 may be at least ten times, at least fifty times, at least one hundred times, or even at least one thousand times the cross-sectional area of a single, separate conducting element of the second section 620. The sum of the individual cross-sectional areas of the plurality of separate conducting elements comprised in the second section 620 may equal the cross-sectional area of the first section 610, or may be less than 10% smaller or larger than the cross-sectional area of the first section 610.

Figure 5 schematically illustrates different kinds of wires in order to describe the general principle of the second section 620. On the left side of Figure 5, a conducting element 80 comprising a single wire 82 having a first cross-sectional area is schematically illustrated. Towards the right side of Figure 5, the conducting elements 80 are formed by more and more separate wires 82. As the number of wires 82 increases, the cross-sectional area of each of the separate wires 82 decreases. The sum of the cross-sectional areas of the individual wires 82 forming the respective conducting element 80, however, may always equal the first cross-sectional area. Each of the different conducting elements 80, therefore, is able to conduct the same amount of current. A stiffness of the conducting element 80, however, decreases from the very left conducting element 80 towards the very right conducting element 80.

The second section 620 may be electrically and mechanically connected to the substrate 10 with a first end, and may be electrically and mechanically connected to the first section 610 with a second end, opposite the first end. That is, the second section 620 may form a connecting element between the first section 610 and the substrate 10. When force is exerted on the first section 610 and the second section 620 during the operation of a power semiconductor module arrangement 100, the second section 620 is able to elastically deform and compensate the force to a certain degree. Therefore, the force is not, or at least not entirely transferred to the connection formed between the second section 620 and the substrate 10. The lifetime of the power semiconductor module arrangement 100, therefore, may be significantly increased, as the connection is less likely to fail.

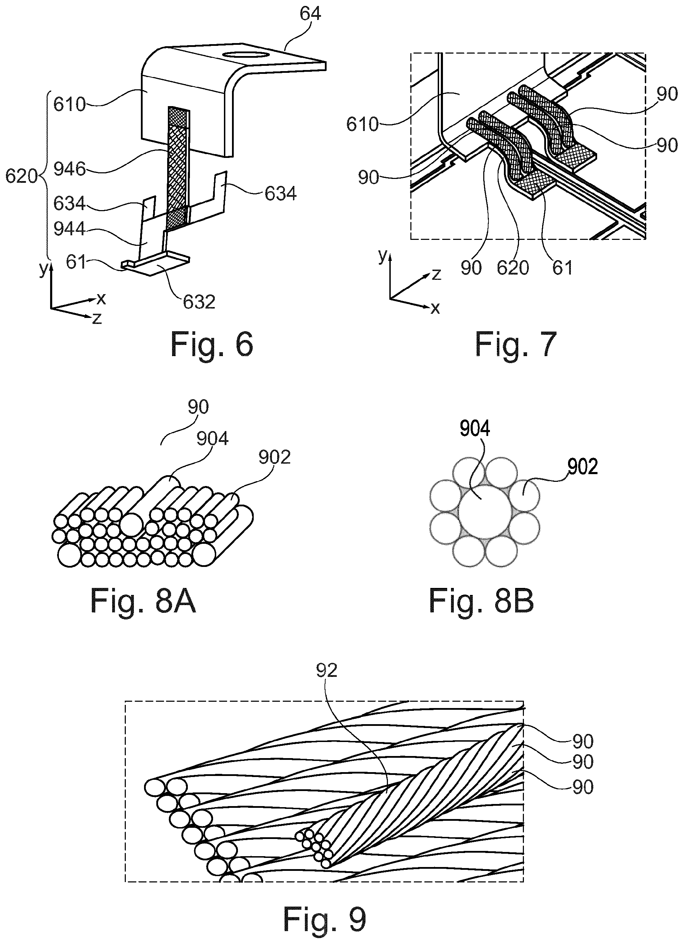

The second section 620 may be implemented in any suitable way. Several exemplary embodiments will be described in the following. Now referring to Figure 6, the second section 620 may comprise a flexible section 946 and a rigid section 944. The flexible section 946 in this example comprises a stranded wire or a flat woven rope. A stranded wire comprises a plurality of wires that are twisted into a bundle, and a flat woven rope comprises a plurality of wires that are woven or braided in any suitable way. In the example of Figure 6, the flexible section 946 (i.e., the stranded wire or flat woven rope) is not connected to the substrate 10 directly. The rigid section 944 is arranged between the flexible section 946 and the substrate 10, and is arranged at or forms the first end 61 of the conductor rail 6. The rigid section 944 has a larger stiffness than the flexible section 946. The rigid section 944 may comprise a connection piece 632 that is configured to be arranged on and connected to the substrate 10. The connection piece 632 may provide a large cross-sectional area for forming a connection with the substrate 10, for example. The rigid section 944 may further comprise one or more protrusions 634, for example. The protrusions 634 may be configured to be grabbed by a positioning tool. This allows to position the connection piece 632 in a desired position during a connection process (e.g., when the second section 620 is connected to the substrate 10 by means of ultrasonic welding, sintering or soldering). That is, the rigid section 944 allows the second section 620 to be easily handled and positioned. The flexible section 946 that is arranged between the first section 610 and the rigid section 944, allows a movement of the first section 610 with regard to the rigid section 944 in two directions in space (e.g., in a first horizontal direction x and a vertical direction y). This is generally sufficient in order to prevent thermo-mechanical stress to be transmitted from the first section 610 to the rigid section 944.

As is schematically illustrated in Figure 7, the second section 620 may also only comprise a flexible section that is directly connected to the substrate 10, without a rigid section arranged in between. In the example illustrated in Figure 7, the second section 620 (i.e., the flexible section) comprises a plurality of braided wires 90. Each of the plurality of braided wires 90 comprises a plurality of separate wires that are braided to form the larger braided wire 90. Each of the plurality of separate wires of a braided wire 90 may comprise the same cross-sectional area, for example. A braided wire 90 that provides a desired flexibility during the use of the power semiconductor module arrangement 100, however, due to its flexibility, may not be easy to handle while forming the connection between the second section 620 and the substrate 10.

Therefore, according to the invention and as is schematically illustrated in Figures 8A and 8B, a braided wire 90 comprises a first plurality of separate wires of a first kind 902, the wires of the first kind 902 each having a first cross-sectional area, and one or more wires of a second kind 904 each having a second cross-sectional area that is larger than the first cross-sectional area. According to one embodiment of the disclosure, the second cross-sectional area is at least 1.5 times larger than the first cross-sectional area. The one or more wires of the second kind 904 provide a certain amount of stability while forming the connection between the second section 620 and the substrate 10, as the thicker wires of the second kind 904 are not as flexible as the wires of the first kind 902. A braided wire 90 comprises at least one wire of the second kind 904. A braided wire comprising exactly one wire of the second kind 904 is schematically illustrated in Figure 8B. In the example illustrated in Figure 8B, a plurality of wires of the first kind 902 is arranged to surround the single wire of the second kind 904. For example, the wires of the first kind 902 may be twisted around the wire of the second kind 904, similar to what has been described with respect to Figure 5 above.

A braided wire 90, however, may also include more than one wire of the second kind 904, as is exemplarily illustrated in Figure 8A. In the example illustrated in Figure 8A, the braided wire 90 comprises three wires of the second kind 904. The number of wires of the first kind 902 may be larger than the number of wires of the second kind 902. The wires of the first and second kind 902, 904 illustrated in Figure 8A are only schematically illustrated for illustration purposed of the general principle and may be braided or twisted in any suitable way to form a braided wire 90.

The one or more wires of the second kind 904 may not be necessarily required to conduct a current. That is, the plurality of wires of the first kind 902 is sufficient in order to conduct the currents required in a specific power semiconductor module arrangement 100 (the sum of the individual cross-sectional areas of the plurality of wires of the first kind 902 is large enough to conduct the required currents). The one or more wires of the second kind 904, while intact, may further add to a total cross-sectional area. Due to the stiffness of the wires of the second kind 904, however, they may break during the use of the power semiconductor module arrangement 100, due to the thermos-mechanical stress exerted on them. If a wire of the second kind 904 breaks, the overall cross-sectional area will be reduced. The minimally required cross-sectional area, however, is still provided by the plurality of wires of the first kind 902. That is, even if one or all of the wires of the second kind 904 break during the operation of the power semiconductor module arrangement 100, the braided wire 90 is still able to conduct the currents occurring in the power semiconductor module arrangement 100.

According to one example, a braided wire 90 comprises one wire of the second kind 904 and two or more wires of the first kind 902. Any number n of wires of the first kind 902 with n ≥ 2 is possible. The number n of wires of the first kind 902 generally depends on the cross-sectional area of a single one of the plurality of wires of the first kind 902, the number of braided wires 90 forming the second section 620, and the cross-sectional area required to conduct the current to be provided by the respective conductor rail 6, for example. The number m of wires of the second kind 904 may be m ≥ 1. The number of wires of the second kind 904, however, should be kept as small as possible in order to maintain the flexibility of the braided wire 90. The number m of wires of the second kind 904 may just be large enough in order to provide sufficient stability to be able to position and connect the braided wires 90 to the substrate 10.

Now referring to Figure 9, the flexible section 946 of a second section 620 may comprise at least one flat woven rope 92. A flat woven rope 92 may comprise three or more braided wires 90, for example, that are woven or braided in any suitable way to form the flat woven rope 92. Weaving a plurality of braided wires 90 together provides further stability to the braided wires 90, while still providing flexibility in at least two directions in space. Each of the braided wires 90 of a flat woven rope 92 may comprise a plurality of wires that each have the same cross-sectional area. It is, however, also possible to implement one or more braided wires 90 of a flat woven rope 92 in the same way as has been described with respect to Figures 8A and 8B above. The stability provided by the wires of the second kind 904, however, may not be required in a flat woven rope, as the flat woven rope 92 itself, due to the weaving, already provides a certain amount of stability to allow it being handled while forming a connection between the flat woven rope 92 and the substrate 10. A flat woven rope 92 generally has a width that is larger than its thickness, e.g., at least three times the thickness, or at least five times the thickness. A length of the woven rope 92 is significantly larger (e.g., at least ten times, at least 30 times or at least 50 times) than both the width and the thickness.

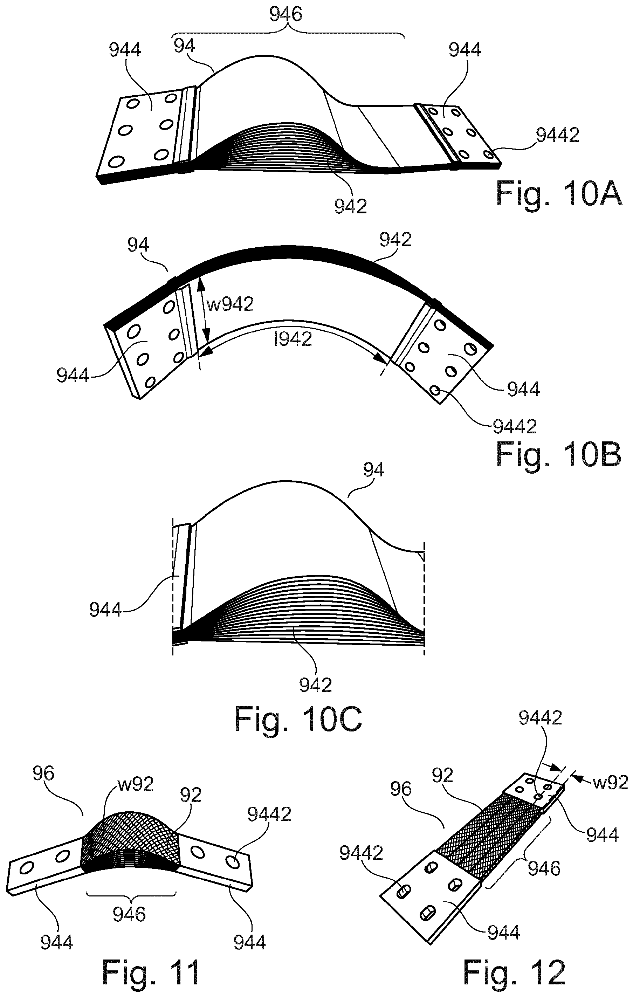

Now referring to Figure 10, it is also possible that the flexible section 946 of the second section 620 comprises a plurality of thin electrically conducting (e.g., metal) foils 942 stacked above one another. Figure 10A, 10B and 10C schematically illustrate different three-dimensional views of a stack of foils 94. Each of the separate metal foils 942 of the stack of foils 94 may not be able to conduct the entire load current required to be conducted by the second section 620. Each metal foil 942 has a comparably large width w942 and length 1942. The thickness of each of the foils 942, however, is thin, e.g., less than 0.5mm, or less than 0.1mm, resulting in a comparably small cross-sectional area of each individual foil 942. With each of the individual foils 942 being comparably thin, the stack of foils 94 is still flexible in two directions in space, as each of the separate foils 942 is flexible. The second section 620 may further comprise two rigid sections 944 that join the individual foils 942 together on two opposite ends. Each of the rigid sections 944 may comprise a clip or any other kind of joining element that is configured to clamp or otherwise join, merge or laminate the individual foils 942 of the stack of foils 94. One of the rigid sections 944 may be connected to the substrate 10, and the other one of the rigid sections 944 may be connected to the first section 910, for example. For example, between two and 50 foils, or between two and 100 foils may be stacked to form the stack of foils 94. Any other number of foils 942 is also possible. The sum of the cross-sectional areas of the individual foils 942 is large enough to be able to conduct the required currents.

Now referring to Figure 11, it is also possible to combine the embodiments as have been described with respect to Figures 9 and 10 above. That is, instead of a stack of foils 94, the flexible section 946 of the second section 620 may comprise a stack of flat woven ropes 92. In the embodiment that has been described with respect to Figure 9 above, the flexible section 946 comprises a single flat woven rope 92 that, however, is comparably thick. A certain thickness of a flat woven rope 92 may be achieved, e.g., by using a larger number of individual braided wires 90, using a larger number of individual wires 902, 904 for each of the braided wires 90, or using individual wires 902, 904 having a larger diameter. In the example illustrated in Figure 11, each of the flat woven ropes 92 of the stack 96 is thinner as compared to the flat woven rope 92 that has been described with respect to Figure 9. That is, less wires or wires having a smaller cross-sectional area may be used for the flat woven ropes 92 of Figure 11, as compared to the flat woven rope 92 of Figure 9. Each of the flat woven ropes 92 in the example of Figure 11 may have a thickness of, e.g., less than 1mm, or less than 0.5mm. A stack of flat woven ropes 96 may comprise between two and 15 flat woven ropes 92, or between two and 30 flat woven ropes 92, or between two and 80 flat woven ropes 92, for example. Any other number of flat woven ropes 92 is also possible. Due to the stacking and the woven structure of the flat woven ropes 92, the stack of flat woven ropes 96 is stiff enough to allow the second section 620 to be arranged in a desired position when forming the connection between the second section 620 and the substrate 10. The second section 620, however, is also flexible enough such that it may be bent into a desired shape shortly before forming the connection. The second section 620 may comprise rigid sections 944, similar to the rigid sections 944 that have been described with respect to Figure 10 above. The stack of flat woven wires 96 allows a certain amount of rotation as well, as compared to the stack of foils 94 of Figure 10, for example.

In the examples illustrated in Figures 10 and 11, the rigid sections 944 each comprise a plurality of through holes 9442. The through holes 9442 may be used to hold and/or position the rigid sections 944. The through holes 9442, however, are not required and may be omitted.

In the example illustrated in Figure 11, each layer of the stack of flat woven ropes 96 is formed by a single flat woven rope 92. That is, a width w92 of each of the plurality of flat woven ropes 92 corresponds to the width of the flexible section 946 of the second section 620. Now referring to Figure 12, it is alternatively also possible that each layer of the stack of flat woven ropes 96 is formed by two or more flat woven ropes 92 that are arranged in one and the same plane. In the example illustrated in Figure 12, each layer of flat woven ropes 92 comprises four flat woven ropes 92 arranged next to each other in the same plane. That is, the width w92 of each of the separate flat woven ropes 92 is less than the width of the flexible section 946. In the example of Figure 12, the width of the flexible section 946 essentially equals four times the width w92 of the individual flat woven ropes 92. The overall number of flat woven ropes 92 in this example is the number of flat woven ropes 92 arranged in each layer multiplied by the number of layers. The number of layers may be similar to what has been described with respect to Figure 11 above. The number of flat woven ropes 92 in each of the separate layers may be between two and five, or between two and 10, for example.

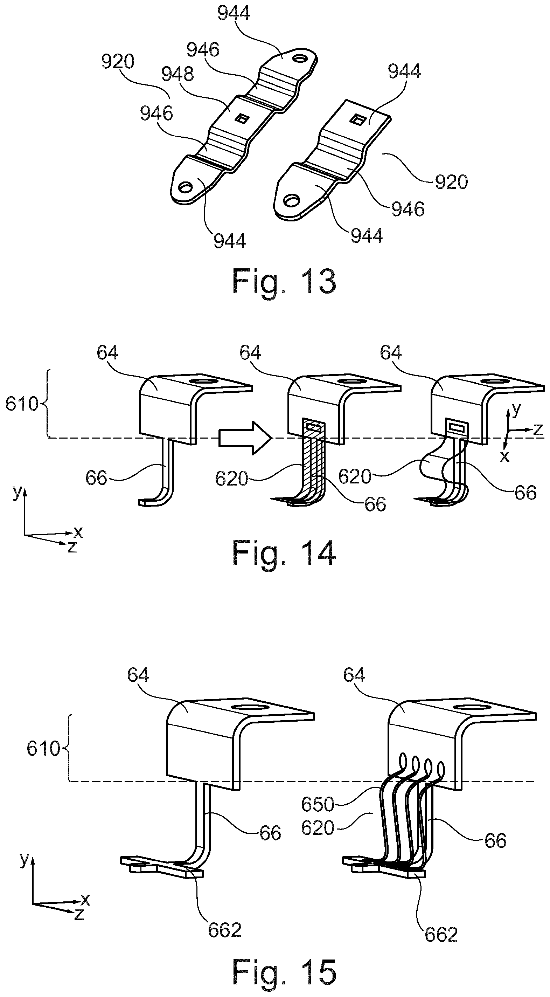

As has been described above, the second section 620 may comprise a flexible section 946 only (see, e.g., Figure 7). It is also possible that the second section 620 comprises exactly one flexible section 946 and exactly one rigid section 944 (see, e.g. Figure 6). In the examples illustrated in Figures 10, 11 and 12, the second section 620 comprises one flexible section 946 arranged between two rigid sections 944. This is schematically illustrated in Figure 13 on the right. In all of the different examples, the flexible section 946 may be implemented in any suitable way, e.g., according to any one of the examples of Figures 6 to 12. Rigid sections 944 may be configured to bind together a plurality of foils 942 or a plurality of flat woven ropes 92, for example. Even further, rigid sections 944 are comparably stiff, as compared to the flexible section 946. That is, a stiffness of each of the rigid sections 944 may be at least five times, at least ten times, or at least fifty times the stiffness of the flexible section 946, for example. The rigid sections 944, therefore, may be easily handled when they are being arranged on the substrate 10 and when a connection is formed between the second section 620 (e.g., one of the rigid sections 944) and the substrate 10. During the operation of the power semiconductor module arrangement 100, the flexible section 946 provides sufficient flexibility in order to prevent the connection formed between the second section 620 and the substrate 10 from being damaged. A second section 620 comprising only one flexible section 946 and none, one or two rigid sections 944, however, is only an example. As is illustrated in Figure 13 on the left side, it is also possible that the second section 620 comprises two flexible sections 946. An additional rigid section 948 may be arranged between the two flexible sections 946, thereby providing an additional positioning element. That is, the additional rigid section 948 may be grabbed by a positioning tool and may be held in a desired position while the connection between the second section 620 (e.g., one of the rigid sections 944) and the substrate 10 is being formed. It is even possible that a second section 620 comprises even more than two flexible sections 946, with an additional rigid section 948 arranged between two subsequent flexible sections 946.

As has been described with respect to Figure 3 above, conventional conductor rails 6 often comprise a large metal sheet 64 having one or more legs 66. A large metal sheet 64 comprising one leg 66 is schematically illustrated in Figure 14, left side. The large metal sheet 64 forms the first, stiff section 610. According to one example, the second section 620 may replace the one or more legs 66. As is schematically illustrated in Figure 14 middle and right side, it is however also possible that a conductor rail 6 comprises a second section 620 in addition to the one or more legs 66, wherein each of the at least one leg 66 has a larger stiffness than each of the at least one flexible section 946 of the second section 620. In the example illustrated in Figure 14, the conductor rail 6 comprises one leg 66 and one second section 620, wherein the second section 620 is arranged electrically in parallel to the leg 66. A conductor rail 6, however, may also comprise a plurality of legs 66 and one second section 620 arranged in parallel to the plurality of legs 66. It is also possible that a conductor rail 6 comprises a plurality of second sections 620 as well as a plurality of legs 66, for example. Different legs 66 and second sections 620 may be used to electrically contact different sections of a first metal layer 111, for example, as is schematically illustrated in Figures 3 and 7 for different lags 66 of a conductor rail 6, for example. A second section 620 may be arranged in parallel to one or more legs 66 between the first section 610 and the substrate 10 (substrate 10 not specifically illustrated in Figure 14). The one or more legs 66 may provide stability when arranging the conductor rail 6 on the substrate 10 and while forming the connection between the conductor rail 6 and the substrate 10.

The leg 66, as compared to the flexible section 620, is stiff. Therefore, during the operation of the power semiconductor module arrangement 100, due to the thermos-mechanical stress exerted on the leg 66, the leg 66 may be damaged or even break. The second section 620 however, due to its flexibility, is not damaged and provides the required electrical connection between the substrate 10 and the first section 610 even if the leg 66 is damaged. When the leg 66 is intact, it contributes to the cross-sectional area that is available to conduct the current between the substrate 10 and the first section 610. The second section 620 alone, however, provides a cross-sectional area that is large enough to be able to conduct the required currents. Therefore, if the leg 66 is damaged or breaks, the power semiconductor module arrangement 100 may still be operated without limitations.

The second section 620, as is schematically illustrated in Figure 14, middle, may be stretched out between the substrate 10 and the first section 610, after the connection between the second section 620 and the substrate 10 has been formed. As is schematically illustrated in Figure 14, right side, however, it is also possible that the second section 620 is curved or arched. That is, a length of the second section 620 may be larger than a distance between the substrate 10 and the first section 610 such that the flexible section of the second section 620 forms at least one arch or loop. The at least one arch or loop further increases the flexibility of the second section 620.

In the example illustrated in Figure 14, the second section 620 is illustrated as an extensive, flat element (see, e.g., flexible section 946 of Figures 6, 9, 10, 11, 12). It is, however, also possible that the second section 620 comprises one or more braided wires 90, similar to what has been described with respect to Figure 7 above. A second section 620 arranged in parallel to one or more legs 66, as described with respect to Figure 14, generally may be implemented in any other suitable way as well. For example, the second section 620 may also comprise one or more rigid sections 944 and more than one flexible section 946, similar to what has been described above.

Now referring to Figure 15, it is also possible that, instead of an extensive, flat element, the second section 620 comprises a plurality of bonding wires 650. The first end of the leg 66 in the example illustrated in Figure 15 comprises an elongated bar 662 which provides a surface area that is large enough to form a bond connection between the first end of each of the bonding wires 650 and the first end of the leg 66. A second end of each of the bonding wires 650 may be connected to the large metal sheet 64 forming the first section 610, for example. In this way, the plurality of bonding wires 650 is arranged in parallel to the leg 66. As has been described with respect to Figure 14 above, the leg 66 is only required to provide stability while arranging the conductor rail 6 on the substrate 10 and while forming a connection between the conductor rail 6 and the substrate. The leg 66, however, may break during the use of the power semiconductor module arrangement 100. The cross-sectional area provided by the plurality of bonding wires 650 is sufficient to conduct the currents which generally occur in a power semiconductor module arrangement 100.

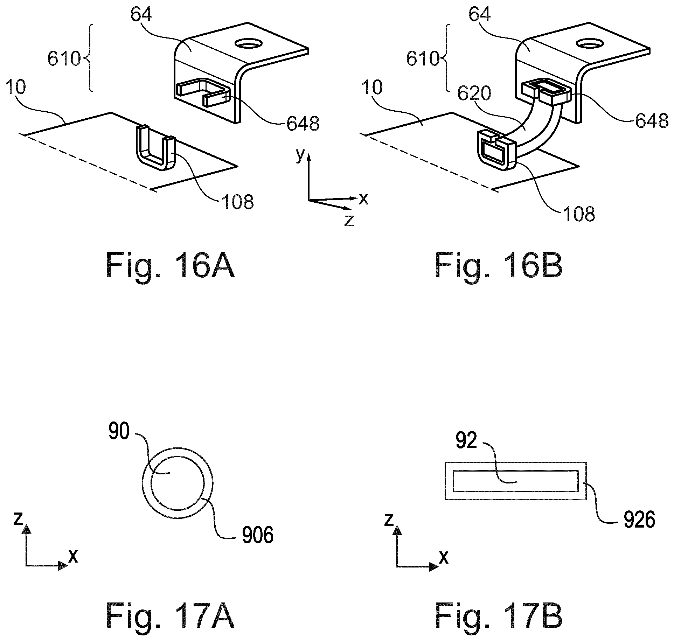

The second section 620 may be connected to the first section 610 in any suitable way. For example, the second section 620 may be soldered, sintered or welded (e.g., by means of ultrasonic welding) to the first section 610. As is schematically illustrated in Figure 16, it is also possible, for example, to connect the second section 620 to the substrate 10 and/or to the first section 610 by means of a crimp connection. That is, a first terminal 108 may be arranged on the substrate 10, and a second terminal 648 may be arranged on the first section 610 (i.e., on the large metal sheet 64). The first and second terminals 108, 648 may be connected to the substrate 10 and the first section 610 by means of a soldered, sintered or welded connection (e.g., ultrasonic welding), for example. A first end of the second section 620 (e.g., one or more braided wires 90, one or more flat woven ropes 92, or one or more layers 942) may be inserted into the first terminal 108 and the first terminal 108 may then be compressed and reshaped to clamp and squeeze the first end of the second section 620. For example, the terminal 108 during this process may be cold-welded onto the first end of the second section 620. A second end of the second section 620 may be clamped by the second terminal 648 in a similar way. Figure 16A schematically illustrates the first terminal 108 arranged on the substrate 10 and the second terminal 648 arranged on the first section 610 in an initial state without the second section 620 arranged therein. Figure 16B schematically illustrates the final crimp connection. That is, the second section 620 is firmly held by the terminals 108, 648 in Figure 16B.

The crimp connection may be any kind of crimp connection and is not restricted to the exemplary crimp connection schematically illustrated in Figure 16. In the example illustrated in Figure 16, a crimp connection is used to connect the second section 620 to the substrate 10 and another crimp connection is used to connect the second section 620 to the first section 610. It is, however, also possible to form only one of the two connections by means of a crimp connection. According to one example, the second section 620 is connected to the first section 610 by means of sintering, soldering or welding. The first section 610 with the second section 620 connected thereto may then be arranged in the power semiconductor module arrangement 100 and a crimp connection may be formed to connect the second section 620 to the substrate 10, as has been described above. The terminals 108, 648 illustrated in Figure 16 are simple U-shaped terminals, the free legs of which may be bent in order to form the crimp connection. The terminals 108, 648, however, may have any other suitable form instead.

Now referring to Figure 17, it is possible that at least the flexible section 946 of the second section 620, e.g., braided wire 90 or flat woven rope 92, is coated by a layer of electrically insulating material 906, 926. Figure 17A schematically illustrates a coated braided wire 90, and Figure 17B schematically illustrates a coated flat woven rope 92. The layer of electrically insulating material 906, 926 may be a shrinking tube, for example, and may comprise a plastic material. One end of a shrinking tube may tightly surround the first end of the braided wire 90 or flat woven rope 92. An opposite end of the shrinking tube may protrude from the encapsulant 5 when the conductor rail 6 has been arranged on the substrate 10 and in the housing 7, and the encapsulant 5 has been filled into the housing 7. The shrinking tube, therefore, may be evacuated through its second end protruding from the encapsulant 5. That is, air may be removed from inside the shrinking tube through its second end. The shrinking tube then tightly surrounds the entire braided wire 90 or flat woven rope 92. In this way, the formation of bubbles inside or close to the braided wire 90 or flat woven rope 92 may be prevented. This may be similarly applied to any other kind of flexible section 946. Even further, the material of the encapsulant 5, which is filled into the housing 7 in a liquid or viscous state before curing it, may be prevented from entering any cavities or voids that may be present between the individual elements (e.g., wires or layers) of a flexible section 946.

## Claims

1. A conductor rail (6) for a power semiconductor module arrangement (100) comprises:
a first end (61) configured to be arranged inside a housing (7) of the power semiconductor module arrangement (100);
a second end (62) configured to be arranged outside of the housing (7) of the power semiconductor module arrangement (100); and
at least a first section (610) and a second section (620) arranged successively between the first end (61) and the second end (62) along a length (16) of the conductor rail (6), wherein
the second section (620) comprises at least one flexible section (946), and
the first section (410) has a larger stiffness than each of the at least one flexible section (946), **characterized in that**
at least one of the at least one flexible section (946) comprises one or more braided wires (90), wherein each of the one or more braided wires (90) comprises a plurality of separate wires that are braided to form the braided wire (90), and
each of the one or more braided wires (90) comprises a first plurality of separate wires of a first kind (902), the wires of the first kind (902) each having a first cross-sectional area, and one or more wires of a second kind (904) each having a second cross-sectional area that is larger than the first cross-sectional area.

2. The conductor rail (6) of claim 1, wherein a stiffness of the first section (610) is at least five times, at least ten times, or at least fifty times the stiffness of each of the at least one flexible section (946).

3. The conductor rail (6) of claim 1 or 2, wherein the second cross-sectional area is at least 1.5 times larger than the first cross-sectional area.

4. The conductor rail (6) of any of the preceding claims, wherein at least one of the at least one flexible section (946) comprises one or more flat woven ropes (92), each of the one or more flat woven ropes (92) comprising three or more braided wires 90 that are woven or braided to form the flat woven rope (92), wherein each of the braided wires (90) comprises a plurality of separate wires that are braided to form the braided wire (90).

5. The conductor rail (6) of claim4, wherein the at least one flexible section (946) comprises a stack (96) comprising a plurality of flat woven ropes (92) stacked above one another.

6. The conductor rail (6) of claim 5, wherein each layer of the stack of flat woven ropes (96) is formed by a single flat woven rope (92), and wherein the stack of flat woven ropes (96) comprises between two and 15 flat woven ropes (92), or between two and 30 flat woven ropes (92), or between two and 80 flat woven ropes (92).

7. The conductor rail (6) of claim5, wherein each layer of the stack of flat woven ropes (96) is formed by two or more flat woven ropes (92) that are arranged in one and the same plane.

8. The conductor rail (6) of any of the preceding claims, wherein at least one of the at least one flexible section (946) comprises a plurality of electrically conducting foils (942) stacked above one another.

9. The conductor rail (6) of claim 8, wherein a thickness of each of the plurality of foils (942) is less than 0.5mm, or less than 0.3mm.

10. The conductor rail (6) of any of the preceding claims, wherein the second section (620) further comprises a rigid section (944) having a larger stiffness than the at least one flexible section (946), wherein
the rigid section (944) is arranged at or forms the first end (61) of the conductor rail (6), and
the rigid section (944) comprises one or more protrusions (634) that are configured to be grabbed by a positioning tool.

11. The conductor rail (6) of any of the preceding claims, further comprising at least one leg (66) arranged in parallel to the second section (620) between the first section (610) and the first end (61) of the conductor rail (6), wherein each of the at least one leg (66) has a larger stiffness than each of the at least one flexible section (946).

12. A power semiconductor module arrangement comprising,
a housing (7);
a substrate (10) arranged inside the housing (7); and
at least one conductor rail (6) according to any of claims 1 to 11, wherein the first end (61) of each of the at least one conductor rail (6) is arranged inside the housing (7) and electrically and mechanically coupled to the substrate (10), and the second end (62) of each of the at least one conductor rail (6) extends to the outside of the housing (7).

13. The power semiconductor module arrangement of claim 12, wherein the entire second section (620) of the conductor rail (6) is arranged inside the housing (7).

## Patentansprüche

1. Stromschiene (6) für eine Leistungshalbleitermodulanordnung (100), umfassend:
ein erstes Ende (61), das ausgelegt ist, innerhalb eines Gehäuses (7) der Leistungshalbleitermodulanordnung (100) angeordnet zu werden;
ein zweites Ende (62), das ausgelegt ist, außerhalb des Gehäuses (7) der Leistungshalbleitermodulanordnung (100) angeordnet zu werden; und
mindestens einen ersten Abschnitt (610) und einen zweiten Abschnitt (620), die zwischen dem ersten Ende (61) und dem zweiten Ende (62) entlang einer Länge (16) der Stromschiene (6) nacheinander angeordnet sind, wobei der zweite Abschnitt (620) mindestens einen flexiblen Abschnitt (946) umfasst, und
der erste Abschnitt (410) eine größere Steifigkeit als jeder der mindestens einen flexiblen Abschnitte (946) aufweist, **dadurch gekennzeichnet, dass**
mindestens einer der mindestens einen flexiblen Abschnitte (946) einen oder mehrere geflochtene Drähte (90) umfasst, wobei jeder des einen oder der mehreren geflochtenen Drähte (90) eine Mehrzahl separater Drähte umfasst, die geflochten sind, um den geflochtenen Draht (90) zu bilden, und jeder des einen oder der mehreren geflochtenen Drähte (90) eine erste Mehrzahl separater Drähte einer ersten Art (902) umfasst, wobei die Drähte der ersten Art (902) jeweils eine erste Querschnittsfläche aufweisen, und einen oder mehrere Drähte einer zweiten Art (904) umfasst, die jeweils eine zweite Querschnittsfläche aufweisen, die größer als die erste Querschnittsfläche ist.

2. Stromschiene (6) nach Anspruch 1, wobei eine Steifigkeit des ersten Abschnitts (610) mindestens das Fünffache, mindestens das Zehnfache oder mindestens das Fünfzigfache der Steifigkeit jedes der mindestens einen flexiblen Abschnitte (946) beträgt.

3. Stromschiene (6) nach Anspruch 1 oder 2, wobei die zweite Querschnittsfläche mindestens 1,5-mal größer als die erste Querschnittsfläche ist.

4. Stromschiene (6) nach einem der vorhergehenden Ansprüche, wobei mindestens einer der mindestens einen flexiblen Abschnitte (946) ein oder mehrere flache gewebte Seile (92) umfasst, wobei jedes des einen oder der mehreren flachen gewebten Seile (92) drei oder mehr geflochtene Drähte (90) umfasst, die gewebt oder geflochten sind, um das flache gewebte Seil (92) zu bilden, wobei jeder der geflochtenen Drähte (90) eine Mehrzahl separater Drähte umfasst, die geflochten sind, um den geflochtenen Draht (90) zu bilden.

5. Stromschiene (6) nach Anspruch 4, wobei der mindestens eine flexible Abschnitt (946) einen Stapel (96) umfasst, der eine Mehrzahl flach gewebter Seile (92) umfasst, die übereinander gestapelt sind.

6. Stromschiene (6) nach Anspruch 5, wobei jede Lage des Stapels flacher gewebter Seile (96) durch ein einzelnes flaches gewebtes Seil (92) gebildet ist, und wobei der Stapel flacher gewebter Seile (96) zwischen zwei und 15 flache gewebte Seile (92), oder zwischen zwei und 30 flache gewebte Seile (92), oder zwischen zwei und 80 flache gewebte Seile (92) umfasst.

7. Stromschiene (6) nach Anspruch 5, wobei jede Lage des Stapels flacher gewebter Seile (96) durch zwei oder mehr flache gewebte Seile (92) gebildet ist, die in ein und derselben Ebene angeordnet sind.

8. Stromschiene (6) nach einem der vorhergehenden Ansprüche, wobei mindestens einer der mindestens einen flexiblen Abschnitte (946) eine Mehrzahl elektrisch leitender Folien (942) umfasst, die übereinander gestapelt sind.

9. Stromschiene (6) nach Anspruch 8, wobei eine Dicke jeder der Mehrzahl von Folien (942) kleiner als 0,5 mm oder kleiner als 0,3 mm ist.

10. Stromschiene (6) nach einem der vorhergehenden Ansprüche, wobei der zweite Abschnitt (620) ferner einen starren Abschnitt (944) umfasst, der eine größere Steifigkeit als der mindestens eine flexible Abschnitt (946) aufweist, wobei
der starre Abschnitt (944) am ersten Ende (61) der Stromschiene (6) angeordnet ist oder dieses bildet, und der starre Abschnitt (944) einen oder mehrere Vorsprünge (634) umfasst, die ausgelegt sind, von einem Positionierungswerkzeug gegriffen zu werden.

11. Stromschiene (6) nach einem der vorhergehenden Ansprüche, ferner umfassend mindestens einen Schenkel (66), der parallel zu dem zweiten Abschnitt (620) zwischen dem ersten Abschnitt (610) und dem ersten Ende (61) der Stromschiene (6) angeordnet ist, wobei jeder der mindestens einen Schenkel (66) eine größere Steifigkeit als jeder der mindestens einen flexiblen Abschnitte (946) aufweist.

12. Leistungshalbleitermodulanordnung, umfassend:
ein Gehäuse (7);
ein Substrat (10), das innerhalb des Gehäuses (7) angeordnet ist; und
mindestens eine Stromschiene (6) nach einem der Ansprüche 1 bis 11, wobei das erste Ende (61) jeder der mindestens einen Stromschiene (6) innerhalb des Gehäuses (7) angeordnet und elektrisch und mechanisch mit dem Substrat (10) gekoppelt ist und sich das zweite Ende (62) jeder der mindestens einen Stromschiene (6) zur Außenseite des Gehäuses (7) erstreckt.

13. Leistungshalbleitermodulanordnung nach Anspruch 12, wobei der gesamte zweite Abschnitt (620) der Stromschiene (6) innerhalb des Gehäuses (7) angeordnet ist.

## Revendications

1. Un rail (6) conducteur pour un ensemble (100) de module à semiconducteur de puissance comprend :
une première extrémité (61) configurée pour être disposée à l'intérieur d'un boîtier (7) de l'ensemble (100) de module à semiconducteur de puissance ;
une deuxième extrémité (62) configurée pour être disposée à l'extérieur du boîtier (7) de l'ensemble (100) de module à semiconducteur de puissance ; et
au moins une première partie (610) et une deuxième partie (620) disposées successivement entre la première extrémité (61) et la deuxième extrémité (62) le long d'une longueur (16) du rail (6) conducteur, dans lequel
la deuxième partie (620) comprend au moins une partie (946) souple, et
la première partie (410) a une rigidité plus grande que chacune de la au moins une partie (946) souple, **caractérisé en ce que**
au moins l'une de la au moins une partie (946) souple comprend un ou plusieurs fils (90) tressés, dans lequel chacun du un ou des plusieurs fils (90) tressés, comprend une pluralité de fils distincts, qui sont tressés pour former le fil (90) tressé, et
chacun du un ou des plusieurs fils (90) tressés comprend une première pluralité de fils distincts d'un premier type (902), les fils du premier type (902) ayant chacun une surface de section transversale et un ou plusieurs fils d'un deuxième type (904) ayant chacun une deuxième surface de section transversale, qui est plus grande que la première surface de section transversale.

2. Le rail (6) conducteur de la revendication 1, dans lequel une rigidité de la première partie (610) représente au moins cinq fois, au moins dix fois ou au moins cinquante fois la rigidité de chacune de la au moins une partie (946) souple.

3. Le rail (6) conducteur de la revendication 1 ou 2, dans lequel la deuxième surface de section transversale est au moins 1,5 fois plus grande que la première surface de section transversale.

4. Le rail (6) conducteur de l'une quelconque des revendications précédentes, dans lequel au moins l'une de la au moins une partie (946) souple comprend un ou plusieurs câbles (92) tissés plats, chacun du un ou des plusieurs câbles (92) tissés plats comprenant trois ou plusieurs fils (90) tressés, qui sont tissés ou tressés pour former le câble (92) tissé plat, dans lequel chacun des fils (90) tressés comprend une pluralité de fils distincts, qui sont tressés pour former le fil (90) tressé.

5. Le rail (6) conducteur de la revendication 4, dans lequel le au moins une partie (946) souple comprend un empilement (96) comprenant une pluralité de câbles (92) tissés plats empilés les uns sur les autres.

6. Le rail (6) conducteur de la revendication 5, dans lequel chaque couche de l'empilement de câbles (96) tissés plats est formée d'un seul câble (92) tissé plat, et dans lequel l'empilement de fils (96) tissés plats comprend entre deux et 15 câbles (92) tissés plats, ou entre deux et 30 câbles (92) tissés plats ou entre deux et 80 câbles (92) tissés plats.

7. Le rail (6) conducteur de la revendication 5, dans lequel chaque couche de l'empilement de câbles (96) tissés plats est formé de deux ou plus câbles (92) tissés plats, qui sont disposés dans un seul et même plan.

8. Le rail (6) conducteur de l'une quelconque des revendications précédentes, dans lequel au moins l'une de la au moins une partie (946) souple comprend une pluralité de feuilles (942) conductrices de l'électricité empilées les unes sur les autres.

9. Le rail (6) conducteur de la revendication 8, dans lequel une épaisseur de chacune de la pluralité de feuilles (942) est plus petite que 0,5 mm ou plus petite que 0,3 mm.

10. Le rail (6) conducteur de l'une quelconque des revendications précédentes, dans lequel la deuxième partie (620) comprend en outre une partie (944) rigide ayant une rigidité plus grande que la au moins une partie (946) souple, dans lequel
la partie (944) rigide est disposée à ou forme la première extrémité (61) du rail (6) conducteur, et
la partie (944) rigide comprend une ou plusieurs saillies (634), qui sont configurées pour être pris par un outil de mise en position.

11. Le rail (6) conducteur de l'une quelconque des revendications précédentes, comprenant en outre au moins un jambage (66) disposé en parallèle à la deuxième partie (620) entre la première partie (610) et la première extrémité (61) du rail (6) conducteur, dans lequel chacun du au moins un jambage (66) a une rigidité plus grande que chacun de la au moins une partie (946) souple.

12. Un ensemble de module à semiconducteur de puissance comprenant :
un boîtier (7) ;
un substrat (10) disposé à l'intérieur du boîtier (7) ; et
au moins un rail (6) conducteur suivant l'une quelconque des revendications précédentes 1 à 11, dans lequel la première extrémité (61) de chacun du au moins un rail (6) conducteur est disposé à l'intérieur du boîtier (7) et est accouplé électriquement et mécaniquement au substrat (10), et la deuxième extrémité (62) de chacun du au moins un rail (6) conducteur s'étend à l'extérieur du boîtier (7).

13. L'ensemble de module à semiconducteur de puissance de la revendication 12, dans lequel toute la deuxième partie (620) du rail (6) conducteur est disposée à l'intérieur du boîtier (7).
